Europäisches Patentamt

European Patent Office

Office européen des brevets

(19)

(11) Numéro de publication : **0 065 460**
**B1**

(12) **FASCICULE DE BREVET EUROPÉEN**

(45) Date de publication du fascicule du brevet :
**18.09.85**

(51) Int. Cl.⁴ : **H 03 M   7/00, G 06 F   7/50**

(21) Numéro de dépôt : **82400847.8**

(22) Date de dépôt : **07.05.82**

(54) **Compteur parallèle en circuit intégré MOS et application à la réalisation d'un additionneur binaire.**

(30) Priorité : **08.05.81 FR 8109166**

(43) Date de publication de la demande :
**24.11.82 Bulletin 82/47**

(45) Mention de la délivrance du brevet :
**18.09.85 Bulletin 85/38**

(84) Etats contractants désignés :
**DE GB IT NL**

(56) Documents cités :
**IEEE TRANSACTIONS ON COMPUTERS, vol. C-20, no. 12, décembre 1971, pages 1580-1583, New York (USA); C.C. FOSTER et al.: "Counting responders in an associative memory"**
**IBM TECHNICAL DISCLOSURE BULLETIN, vol. 15, no. 9, février 1973, pages 2823-2824, New York (USA); R. KENYON et al.: "Complementary field-effect transistor high-density decoder"**
**IBM TECHNICAL DISCLOSURE BULLETIN, vol. 8, no. 9, février 1966, pages 1188-1189, New York (USA); D.L. MALABY: "M/N parallel counter"**

(73) Titulaire : **ITT INDUSTRIES INC.**
**320 Park Avenue**
**New York, NY 10022 (US)**
**GB IT NL**
**Deutsche ITT Industries GmbH**
**Hans-Bunte-Strasse 19 Postfach 840**
**D-7800 Freiburg (DE)**
**DE**

(72) Inventeur : **Lerouge, Claude Paul Henri**
**4, Place d'Auvergne**
**F-78310 Maurepas (FR)**

(74) Mandataire : **Pothet, Jean**
**c/o ITT Data Systems France S.A. Tour Maine Montparnasse 33, avenue du Maine**
**F-75755 Paris Cedex 15 (FR)**

## Description

La présente invention concerne un compteur parallèle en circuit intégré à transistors MOS, à n entrées et n + 1 sorties et une application de ce compteur à la réalisation d'un additionneur binaire.

La réalisation d'un additionneur permettant d'additionner un grand nombre d'éléments binaires en parallèle est particulièrement intéressante dans le domaine de la réalisation d'un multiplieur où il est nécessaire d'additionner en parallèle plusieurs éléments binaires représentant les produits partiels de même poids. En logique MOS, c'est-à-dire dans le cadre de circuits logiques intégrés utilisant des transistors MOS, il est habituel d'utiliser des additionneurs à trois entrées et deux sorties. Les problèmes de propagation de la retenue et les algorithmes permettant de remédier aux retards introduits par le temps nécessaire à la propagation de la retenue sont bien connus. Cependant, l'information logique devra de toute façon transiter par un certain nombre de portes, généralement des portes OU exclusif, comprenant chacune plusieurs de ces transistors MOS, et la rapidité en sera d'autant plus affectée.

Ainsi, un objet de la présente invention est-il de réaliser un compteur à n entrées et n + 1 sorties, où, dans chaque étage, l'information transite à travers un seul transistor MOS, recevant n variables binaires sur ses n entrées et dans lequel seule la sortie dont le rang correspond au nombre de variables binaires au niveau logique 1 fournit un signal au niveau logique 1.

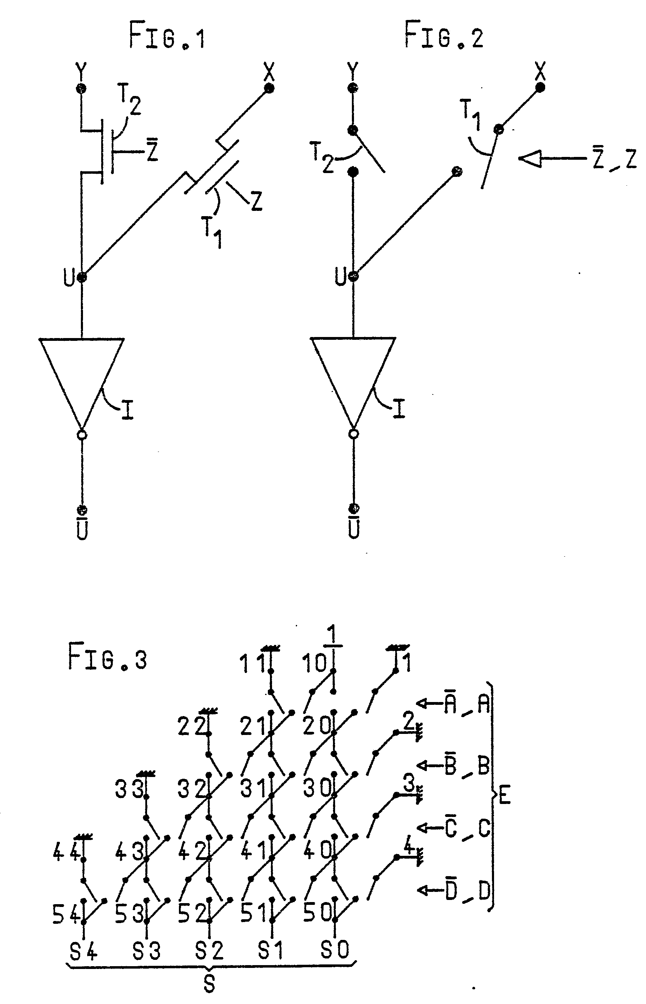

Il existe des compteurs parallèles de ce type, à n entrées et n + 1 sorties, à base de logique à relais. De tels compteurs sont décrits par exemple dans l'article de C.C. Foster et F.D. Stockton, intitulé : 'Counting responders in an associative memory', paru dans la revue IEEE Transactions on Computers, Décembre 1971, pages 1580 (Fig. 1). Ces compteurs sont formés à partir d'une disposition du type « arborescence ». Chaque contact à deux positions, commandé par un relais donné, aiguille une information logique dans l'une ou l'autre des branches qu'il est chargé de gérer. Tous les contacts d'un même niveau de l'arbre sont commandés par un même relais, lui-même étant commandé par une des n variables d'entrée. Cependant, les problèmes dans ces logiques à relais sont différents de ceux dans les circuits utilisant des logiques MOS, ne serait-ce que par les rapidités différentes, et il en est de même des contraintes imposées à de tels circuits, telles par exemple que les nécessités de « mise à la masse » pour obtenir un zéro logique. Ainsi, on ne peut réaliser un compteur parallèle à transistors MOS simplement en remplaçant chaque relais par un transistor MOS car on ne pourrait pas obtenir les niveaux de tension requis sur chacune des sorties.

Selon la présente invention, ce problème est résolu par le fait que ce compteur est constitué d'un réseau de cellules élémentaires en V, comportant chacune deux entrées et une sortie dont la branche de droite comporte un transistor MOS commandé par une variable binaire et dont la branche de gauche comporte un deuxième transistor MOS commandé par le complément de cette variable, ces cellules étant disposées suivant un réseau de forme triangulaire tronquée, la première ligne étant constituée de deux telles cellules élémentaires commandées par la première variable d'entrée et ayant leurs entrées en regard reliées électriquement, la deuxième ligne, commandée par la deuxième variable d'entrée, étant constituée d'une cellule de plus que la première ligne, ces cellules ayant leurs entrées en regard reliées, ces entrées doubles étant reliées aux sorties correspondantes de l'étage précédent, la $i^{ème}$ ligne, commandée par la $i^{ème}$ variable d'entrée, étant constituée de i + 1 cellules, dont les entrées en regard sont reliées et constituent i entrées doubles reliées aux i sorties correspondantes de la ligne précédente, et dont les i + 1 sorties numérotées de gauche à droite de 0 à i sont reliées aux i + 1 entrées doubles correspondantes de la ligne suivante, le $n^{ième}$ niveau, commandé par la $n^{ième}$ variable d'entrée, comportant n + 1 sorties correspondant aux n + 1 sorties du compteur, l'entrée double de la première ligne de cellules recevant le niveau logique 1, et toutes les entrées simples de cellules de toutes les lignes recevant le niveau logique 0, de sorte que seule la sortie, dont le numéro est égal au nombre de variables d'entrée au niveau logique 1, est elle-même au niveau logique 1, les autres étant au niveau 0.

L'invention sera mieux comprise et d'autres caractéristiques apparaîtront à l'aide de la description ci-après et des dessins joints où :

la figure 1 représente une cellule élémentaire en V à transistor MOS ;

la figure 2 représente une schématisation pratique de la cellule selon la figure 1 ;

la figure 3 représente un réseau de cellules constituant un compteur à quatre entrées et cinq sorties ;

la figure 4 représente une variante de la figure 3 dans le cas d'un compteur à trois entrées et son utilisation dans un additionneur binaire ; et

la figure 5 représente un compteur selon la figure 3 avec régénération par circuit inverseur.

Sur la figure 1, est représentée une cellule élémentaire en V non symétrique utilisant des transistors MOS de transfert identiques sur chaque branche mais dont le premier, $T_1$, placé sur la branche oblique du V ou branche de droite, est commandé par la variable binaire Z, et dont l'autre, $T_2$, placé sur la branche verticale du V ou branche de gauche, est commandé par le complément $\bar{Z}$ de cette variable binaire. Si la variable binaire de commande Z est au niveau logique 1, $\bar{Z}$ étant au niveau logique 0, le transistor $T_1$ conduit et le transistor $T_2$ est bloqué. La cellule reproduira alors en U la variable binaire X.

Inversement, si la variable Z est au niveau logique 0, la cellule reproduira en U la variable binaire Y. Cependant, ce transfert d'éléments binaires d'une des entrées vers la sortie s'effectue avec une certaine déformation due aux capacités et résistances parasites du transistor MOS. Si l'on désire placer, à la suite les une des autres, plusieurs de ces cellules, il sera nécessaire de régénérer de façon régulière les sorties de ces cellules. Ceci peut s'effectuer à l'aide d'un circuit inverseur I dont la sortie est alors de façon sûre sur l'un des niveaux logiques 0 ou 1.

Sur la figure 3, est représenté un compteur parallèle, à 4 entrées E et 4 + 1 sorties S, selon l'invention. Celui-ci est constitué à partir de cellules élémentaires, telle celle représentée sur la figure 2, disposées suivant un réseau de forme triangulaire tronqué. La première ligne de cellules au premier étage est constituée de deux telles cellules commandées par la variable binaire d'entrée A : les branches obliques des V sont commandées par la variable A et les branches verticales sont commandées par le complément $\overline{A}$ de cette variable. Les entrées en regard des cellules de la première ligne sont électriquement reliées et constituent une entrée dite entrée double 10, au point de connexion 10 de rang 0 et de ligne 1. Les autres entrées 1 et 11 constituent les entrées simples : le rang de l'entrée 1 n'est pas comptabilisé et l'entrée 11 est une entrée simple de ligne 1 et de rang 1. Les points de connexion 20 et 21, qui constituent les sorties de la première ligne ainsi que les entrées doubles de la seconde ligne, sont désignés par un nombre dont le chiffre des unités représente le rang et le chiffre des dizaines représente le numéro de la ligne dont ils sont les entrées. La deuxième ligne, commandée de la même façon par la deuxième variable d'entrée B, est constituée d'une cellule de plus que la première ligne. Les entrées en regard de chacune de ces cellules sont reliées et constituent des entrées doubles 20 et 21 ; les entrées simples 2 et 22 de deuxième ligne sont de rang non comptabilisé pour la première et de rang 2 pour la seconde. Les sorties de la deuxième ligne 30, 31, 32 sont numérotées de 0 à 2 (0, 1 et 2 constituant le rang de la sortie).

Chaque ligne comportant une cellule élémentaire de plus que la précédente, la quatrième et dernière ligne comporte donc six entrées, dont quatre entrées doubles 40, 41, 42, 43 et deux entrées simples 4 et 44, et cinq sorties 50, 51, 52, 53, 54 de rang 0 à 4.

L'entrée double unique 10 de la première ligne de cellules élémentaires reçoit le niveau logique 1, et toutes les entrées simples des cellules de toutes les lignes reçoivent le niveau logique 0, de sorte que si toutes les variables binaires d'entrée sont à l'état 0, alors toutes les sorties de cellules de rang 0 sont à l'état 1 et toutes les autres sorties de cellules de rang supérieur ou égal à 1 sont à l'état 0.

Le fonctionnement du compteur à quatre entrées peut alors être expliqué de la façon suivante.

Si aucune des variables d'entrée n'est à l'état 1, le niveau logique 1 fourni en 10, ainsi que les niveaux logiques 0 fournis en 11, 22, 33, 44, vont être transmis verticalement sans changement de rang : la sortie 0 sera donc à l'état 1, les sorties S1, S2, S3, S4, de rang supérieur, seront à l'état 0. Chaque fois qu'une variable d'entrée supplémentaire est à l'état 1, la ligne de cellules correspondante décalera le 1 logique, ainsi que tous les 0 logiques, situés à sa gauche, d'un rang vers la gauche. Cette même ligne de cellules introduira aussi, par l'intermédiaire de l'une des entrées 1, 2, 3, 4, un niveau 0 supplémentaire qui sera transmis vers la sortie, avec ou sans changement de rang dans des lignes ultérieures et permettra de mettre à 0 toutes les sorties de rang inférieur au nombre de variables d'entrée à l'état 1.

Si on considère la première cellule de la première ligne, dont les entrées sont 1 et 10 et la sortie 20 fournissant la variable binaire $U_{20}$, et la deuxième cellule de la première ligne, dont les entrées sont 10 et 11 et la sortie 21 fournissant $U_{21}$, toutes deux commandées par la variable binaire A, on constate que les variables sur les sorties s'écrivent :

$$U_{20} = 0\,A + 1\,\overline{A} = \overline{A}$$

$$U_{21} = 1\,A + 0\,\overline{A} = A.$$

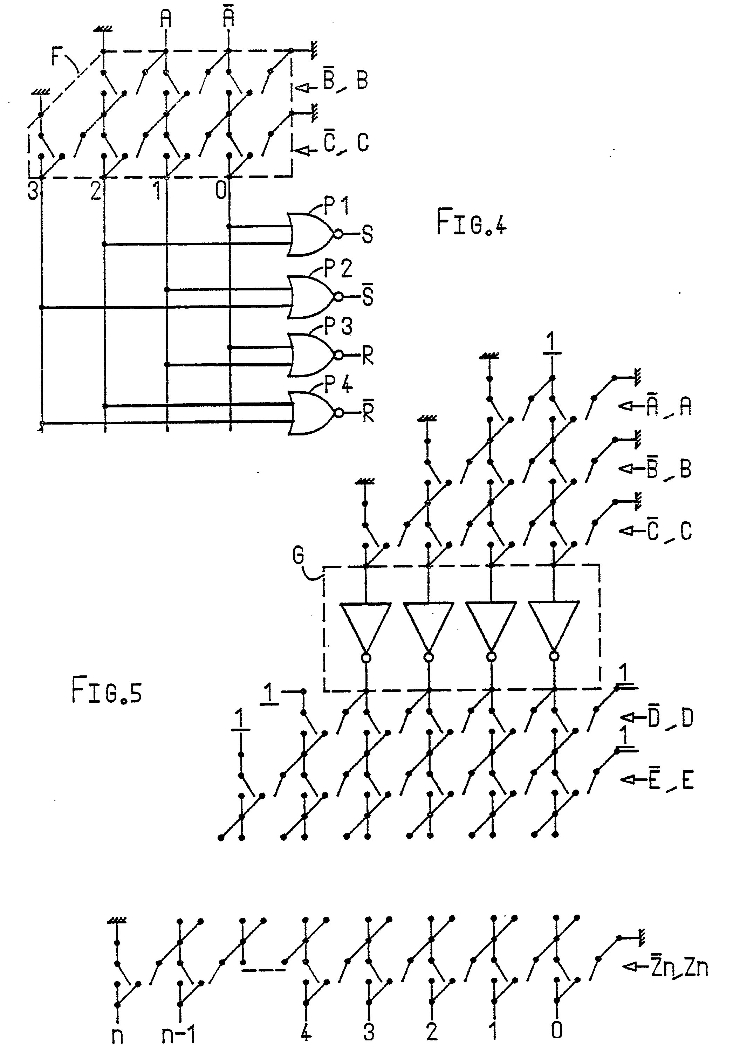

On peut donc supprimer ces deux premières cellules et envoyer directement en 20 et 21 respectivement $\overline{A}$ et A. On obtient alors, en se limitant à trois entrées, le compteur binaire F représenté sur la figure 4 dans le cadre de son utilisation dans un additionneur (3, 2) à trois entrées et deux sorties utilisant le compteur à trois entrées et quatre sorties F et quatre NON-OU $P_1$ à $P_4$ qui fournissent l'élément binaire somme S et l'élément binaire de retenue R de l'addition des trois variables d'entrée A, B, C, ainsi que leurs compléments $\overline{S}$ et $\overline{R}$. Il est possible de réaliser tout type d'additionneur (3, 2), (4, 3), (5, 3), (6, 3), (7, 3), certains, tels que (3, 2) et (7, 3), étant utilisés de façon optimale ou « saturée ».

Sur la figure 5, est représenté un compteur à n entrées et n + 1 sorties avec une régénération des niveaux chaque fois que l'information a traversé trois cellules. Ce nombre relativement faible de trois cellules a été choisi pour simplifier la représentation, mais le nombre k de lignes à partir duquel il est nécessaire d'introduire une régénération peut être supérieur. On réalise une régénération des niveaux logiques grâce à une ligne supplémentaire G de portes inverseuses. Au-delà de cette ligne, les entrées simples des cellules extrêmes devront recevoir un niveau logique 1 si elles recevaient un niveau 0 aux lignes précédentes et inversement. Un nombre pair de telles lignes supplémentaires doit être rajouté entre la première ligne et la sortie du compteur si l'on ne désire pas que les sorties du compteur soient complémentées. Ce compteur à n entrées et n + 1 sorties peut évidemment être utilisé dans le cadre d'un additionneur à n entrées en généralisant le principe du décodage utilisé pour le compteur à trois entrées de la figure 4.

Bien que la présente invention ait été décrite dans le cadre d'exemples de réalisation particuliers, il est clair qu'elle n'est pas limitée auxdits exemples et qu'elle est susceptible de modifications ou de variantes sans sortir de son domaine. En particulier, on pourrait utiliser des lignes de cellules en V commandées par des variables auxquelles est affecté un poids de $2^u$ unités. Celles-ci devraient faire effectuer aux informations binaires un saut de u rangs moyennant une adaptation du nombre de sorties et du nombre de mises à la masse.

**Revendications**

1. Compteur parallèle à n entrées et n + 1 sorties numérotées de 0 à n en circuit intégré, utilisant des transistors MOS de transfert connectés selon une disposition en arborescence, recevant n variables binaires sur ses n entrées et dans lequel seule la sortie dont le rang correspond au nombre de variables binaires au niveau logique 1 fournit un signal au niveau logique 1, caractérisé en ce que ce compteur est constitué d'un réseau de cellules élémentaires en V comportant chacune deux entrées et une sortie dont la branche de droite comporte un transistor MOS ($T_1$) commandé par une variable binaire (Z) et dont la branche de gauche comporte un deuxième transistor MOS ($T_2$) commandé par le complément ($\bar{Z}$) de cette variable (Z), ces cellules étant disposées suivant un réseau de forme triangulaire tronquée, la première ligne étant constituée de deux telles cellules élémentaires commandées par la première variable d'entrée (A) et ayant leurs entrées en regard reliées électriquement, la deuxième ligne, commandée par la deuxième variable d'entrée (B), étant constituée d'une cellule de plus que la première ligne, ces cellules ayant leurs entrées en regard reliées, ces entrées doubles (20, 21) étant reliées aux sorties correspondantes de l'étage précédent, la $i^{ème}$ ligne, commandée par la $i^{ème}$ variable d'entrée, étant constituée de i + 1 cellules, dont les entrées en regard sont reliées et constituent i entrées doubles reliées aux i sorties correspondantes de la ligne précédente, et dont les i + 1 sorties numérotées de droite à gauche de 0 à i sont reliées aux i + 1 entrées doubles correspondantes de la ligne suivante, le $n^{ième}$ niveau, commandé par la $n^{ième}$ variable d'entrée, comportant n + 1 sorties correspondant aux n + 1 sorties du compteur, l'entrée double (10) de la première ligne de cellules recevant le niveau logique 1 et toutes les entrées simples des cellules de toutes les lignes recevant le niveau logique 0, de sorte que seule la sortie, dont le numéro est égal au nombre de variables d'entrée au niveau logique 1, est elle-même au niveau logique 1, les autres étant au niveau 0.

2. Compteur parallèle selon la revendication 1, caractérisé en ce que la première ligne, constituée de deux cellules élémentaires, est supprimée, et en ce que la première entrée double en partant de la droite reçoit le complément de la première variable logique d'entrée ($\bar{A}$) et la deuxième entrée double reçoit cette variable logique (A).

3. Compteur parallèle selon l'une des revendications 1 ou 2, caractérisé en ce qu'au-delà d'un certain nombre k de lignes, et toutes les k lignes, une ligne supplémentaire d'inverseurs (G) est intercalée entre la ligne k et la ligne k + 1, toutes les entrées simples, au-delà de la ligne k, recevant alors le niveau logique 1 si elles recevaient le niveau logique 0 et inversement.

4. Additionneur binaire comportant un compteur parallèle selon l'une quelconque des revendications 1 à 3, caractérisé en ce qu'il comprend un dispositif de décodage ($P_1$ à $P_4$) des n + 1 sorties dudit compteur (F) pour fournir les éléments binaires (S, R) de la somme des n variables d'entrée.

5. Additionneur binaire selon la revendication 4, caractérisé en ce que ledit dispositif de décodage est constitué de portes NON-OU ($P_1$ à $P_4$) dont les entrées sont reliées aux sorties convenables du compteur et dont les sorties fournissent les éléments binaires (S, R) de la somme.

**Claims**

1. A parallel counter with n inputs and n + 1 outputs numbered from 0 to n in an integrated circuit, utilizing MOS transfer transistors, receiving n binary variables at its n inputs and in which only the output whose rank corresponds to the number of binary variables at the logic 1 level furnishes a logic 1 output, characterized in that this counter consists of a network of V-shaped elementary cells, each having two inputs and one output, whose right-hand branch contains an MOS transistor ($T_1$) controlled by a binary variable (Z) and whose left-hand branch contains a second MOS transistors ($T_2$) controlled by the complement ($\bar{Z}$) of this variable (Z), these cells being laid out in a truncated triangularshaped network, the first line consisting of two such elementary cells controlled by the first input variable (A) and having their facing inputs electrically connected, the second line, controlled by the second input variable (B), consisting of one cell more than the first line, these cells having their facing inputs connected together, these double inputs (20, 21) being connected to the corresponding outputs of the preceding stage, the $i^{th}$ line, controlled by the $i^{th}$ input variable, consisting of i + 1 cells, whose facing inputs are connected together and consitute i double inputs connected to the i corresponding outputs of the preceding line, and whose i + 1 outputs numbered from left to right from 0 to i are connected to the i + 1 corresponding double inputs of the following line, the $n^{th}$ level, controlled by the $n^{th}$ input variable, containing n + 1 outputs corresponding to the n + 1 outputs of the counter, the double input (10) of the first line of cells receiving the logic 1 level, and all the single inputs of the cells of all the lines receiving the logic 0 level, so that only the output, whose number is equal to the number of input variables at the logic 1 level, is itself at the logic 1 level, the others being at the level 0.

2. A parallel counter according to claim 1, characterized in that the first line, consisting of two elementary cells, is eliminated and in that the first double input starting from the right receives the complement of the first input variable ($\bar{A}$), and the second double input receives that logic variable (A).

3. A parallel counter according to anyone of claims 1 or 2, characterized in that beyond a certain number k of lines, and every k lines, an additional line (G) of inverters is inserted between the line k and the line k + 1, with all single inputs beyond the line k then receiving the logic 1 level if they received the logic 0 level and vice versa.

4. A binary adder including a parallel counter according to anyone of claims 1 to 3, characterized in that it contains a decoding device ($P_1$ to $P_4$) of the n + 1 outputs of the said counter (F) to furnish the binary elements (S, R) of the sum of the n input variables.

5. A binary adder according to claim 4, characterized in that it comprises NOR gates ($P_1$ to $P_4$) whose inputs are connected to the suitable outputs of the cunter and whose outputs furnish the binary elements (S, R) of the sum.


**Patentansprüche**

1. Als MOS-Schaltung integrierter Parallelzähler mit n Eingängen und n + 1 von 0 bis n durchnumerierten Ausgängen unter Verwendung baumartig verbundener MOS-Transfer-Transistoren bei denen n binäre Variable an seinen n Eingängen liegen und nur derjenige Ausgang ein Signal mit dem Logikpegel 1 liefert, dessen Rang der Anzahl der binären Variablen mit dem Logikpegel 1 entspricht, dadurch gekennzeichnet daß der Parallelzähler aus einem Netzwerk von V-förmigen Elementarzellen besteht, von denen jede zwei Eingänge und einen Ausgang enthält und deren rechter Zweig einen MOS-Transfer-Transistor ($T_1$) enthält, der durch eine binäre Variable (Z) gesteuert ist, und deren linker Zweig einen zweiten MOS-Transfer-Transistor ($T_2$) enthält, der durch das Komplement ($\bar{Z}$) dieser binären Variablen (Z) gesteuert ist, daß das Netzwerk der Elementarzellen in Form eines stumpfen Dreiecks angeordnet ist, daß die erste Zeile aus zwei Elementarzellen gebildet ist, die durch die erste Eingangsvariable (A) gesteuert sind und deren einander zugewandte Eingänge miteinander verbunden sind, daß die zweite Zeile, die durch die zweite Eingangsvariable (B) gesteuert ist, eine Elementarzelle mehr als die erste Zeile hat, die Elementarzellen an ihren einander zugewandten Eingängen miteinander verbunden sind und die so gebildeten Doppeleingänge (20, 21) an den entsprechenden Ausgängen der vorangehenden Zeile liegen, daß die i-te Zeile, die durch die i-te Eingangsvariable gesteuert ist, aus i +1 Elementarzellen besteht, deren einander zugewandte Eingänge miteinander verbunden sind, und aus i Doppeleingängen besteht, die mit i entsprechenden Ausgängen der vorangehenden Zeile verbunden sind und deren i + 1 von rechts nach links zunehmend durchnumerierten (von 0 bis i) Ausgänge mit i + 1 entsprechenden Doppeleingängen der folgenden Zeile verbunden sind, und daß die n-te Zeile, die durch die n-te Eingangsvariable gesteuert ist, aus n + 1 Ausgängen besteht, die die n + 1 Ausgänge des Parallelzählers sind, der Doppeleingang (10) der ersten Zeile an den Logikpegel 1 angeschlossen und alle Einfacheingänge der Elementarzellen aller Zeilen an den Logikpegel 0 angeschlossen sind, so daß allein derjenige Ausgang, dessen Rang gleich der Anzahl der Eingangsvariablen mit dem Logikpegel 1 ist, sich selbst auf dem Logikpegel 1 befindet, während alle anderen Ausgänge den Logikpegel 0 haben.

2. Parallelzähler nach Anspruch 1, dadurch gekennzeichnet, daß die erste Zeile, die aus zwei Elementarzellen gebildet ist, entfällt, und daß dem ersten Doppeleingang, von rechts gesehen, das Komplement der ersten binären Eingangsvariable ($\bar{A}$) und dem zweiten Doppeleingang die binäre Eingangsvariable (A) zugeführt ist.

3. Parallelzähler nach Anspruch 1 oder 2, dadurch gekennzeichnet, daß nach k Zeilen und jeweils weiterer k Zeilen jeweils eine zusätzliche Zeile von Inverten (G) zwischen die Zeilen k und k + 1 eingefügt ist und daß allen Einfacheingängen hinter der Zeile k dann der Logikpegel 1 zugeführt ist, wenn ihnen vorher der Logikpegel 0 zugeführt war und umgekehrt.

4. Binäraddierer mit einem Parallelzähler nach einem der Ansprüche 1 bis 3, dadurch gekennzeichnet, daß der Binärzähler eine Decodierschaltung ($P_1$ bis $P_4$) für die n + 1 Ausgänge des Parallelzählers (F) zur Erzeugung der binären Elemente (S, R) der Summe der n Eingangsvariablen enthält.

5. Binäraddierer nach Anspruch 4, dadurch gekennzeichnet, daß die Decodierschaltung aus NOR-Gattern ($P_1$ bis $P_4$) besteht, deren Eingänge mit den passenden Ausgängen des Parellelzählers verbunden sind und an deren Ausgängen die Binärelemente (S, R) der Summe auftreten.

FIG.1

FIG.2

FIG.3

0 065 460

FIG.4

FIG.5

2